# EUROPEAN PATENT APPLICATION

(11) **EP 4 301 102 A2**
(43) Date of publication of application: **03.01.2024**
(21) Application number: 23181681.0
(22) Date of filing: 27.06.2023
(51) Int. Cl.: H05K 5/02, H05K 7/20

(54) **SPLASH WATER PROTECTED CONTROLLER ENCLOSURE**

(30) Priority: 30.06.2022 US 202263357200 P; 12.06.2023 US 202318208402
(71) Applicant: F.R. Drake Company, Waynesboro, Virginia 22980 (US)
(72) Inventor: RICHARDS, Andre G., Waynesboro, 22980 (US)
(74) Representative: Zacco Denmark A/S

(57) **Abstract**

The present disclosure is directed to a washdown controller enclosure. In one form, a system configured to enclose one or more robot controllers includes a base; an exterior shell configured to couple with the base, the exterior shell defining an interior area sized to enclose a robot controller of an industrial machine; a first cooling fan positioned on the exterior shell, the first cooling fan configured to draw air into the interior area of the exterior shell; and a second cooling fan positioned on the exterior shell, the second cooling fan configured to expel at least one of air or moisture from the interior area of the exterior shell.

## Description

### FIELD OF THE DISCLOSURE

The present disclosure relates to an enclosure designed to enclose and protect a robot controller from water in a washdown environment and/or protect a robot controller from dust in a dusty environment while also providing proper cooling for the enclosed robot controller.

### BACKGROUND

As the usage of robots in industrial settings continue to increase, a challenge of creating robots that can operate within washdown and dusty environments is slowly being met by robot manufacturers. Many manufacturers now have robots that can withstand washdown cycles encountered in food plants and that can be protected against dust in dusty environments. However, one remaining part of a manufacturing system that is not presently protected is the robot controller. Industrial robots utilize a separate robot controller to run the robot. The separate robot controller is where electronics for controlling movement of the industrial robot and for sensing and vision of the industrial robot, among other things, occurs.

### BRIEF SUMMARY OF THE DISCLOSURE

The present disclosure addresses the above-described problem and provides protection to the robot controller in washdown and dusty environments without requiring alteration to the controller itself.

In one aspect, the present disclosure provides a system configured to enclose one or more robot controllers. In one form, a system comprises a base and an exterior shell configured to couple with the base, the exterior shell defining an interior area sized to enclose a robot controller of an industrial machine.

The system further comprises a first cooling fan and a second cooling fan. The first cooling fan is positioned on the exterior shell, wherein the first cooling fan is configured to draw air into the interior area of the exterior shell and the first cooling fan comprises a baffle positioned on the exterior shell that is configured to prevent water from entering the interior area of the exterior shell at the first cooling fan. The second cooling fan is positioned on the exterior shell, wherein the second cooling fan is configured to expel at least one of air or moisture from the interior area of the exterior shell and the second cooling fan comprises a baffle positioned on the exterior shell that is configured to prevent water from entering the interior area of the exterior shell at the second cooling fan.

In some implementations, at least one of the first cooling fan or the second cooling fan further comprises a filter configured to prevent dust from entering the interior area of the disclosure.

The present disclosure further provides a system configured to enclose a plurality of robot controllers for one or more industrial machines. In one form, the system comprises a plurality of enclosures stacked on top of each other, wherein each enclosure comprises a base and an exterior shell configured to couple with the base, the exterior shell defining an interior area sized to enclose a robot controller.

Each enclosure further comprises a first cooling fan and a second cooling fan. The first cooling fan is positioned on the exterior shell, wherein the first cooling fan is configured to draw air into the interior area of the exterior shell and the first cooling fan comprises a baffle positioned on the exterior shell that is configured to prevent water from entering the interior area of the exterior shell at the first cooling fan. The second cooling fan is positioned on the exterior shell, wherein the second cooling fan is configured to expel at least one of air or moisture from the interior area of the exterior shell and the second cooling fan comprises a baffle positioned on the exterior shell that is configured to prevent water from entering the interior area of the exterior shell at the second cooling fan.

In some implementations, at least one of the first cooling fan or the second cooling fan further comprises a filter configured to prevent dust from entering the interior area of the disclosure. In these implementations, the filter may be removable and cleanable.

The disclosure further provides another system that is configured to enclose one or more robot controllers. In one form, the system comprises a base; an exterior shell configured to couple with the base, the exterior shell defining an interior area sized to enclose a robot controller of an industrial machine; and an air conditioning unit positioned on the exterior shell, wherein the air conditioning unit is configured to create a circular airflow at least partially around the robot controller position in the interior area of the exterior shell.

### BRIEF DESCRIPTION OF THE DRAWINGS

Figures 1a and 1b illustrate a fist perspective view and a second perspective view of two enclosures in a stacked configuration. Figure 1c illustrates a cut-away side view of a fan and associated baffles.
Figure 2 illustrates a cut-away top view of an enclosure with arrows showing a direction of air flow around a robot controller.
Figure 3 illustrates the enclosure with an exterior shell removed with a robot controller and internal baffles mounted to a base and visible.
Figure 4 is a partially exploded view illustrating an exterior shell removed from the robot controller and the base.

### DETAILED DESCRIPTION OF THE DISCLOSURE

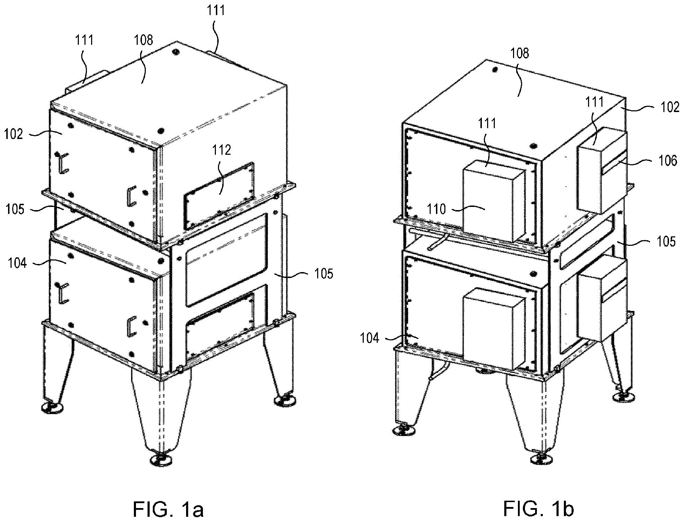

Figure 1a illustrates a first perspective view and Figure 1b illustrates a second perspective view of a first enclosure 102 for a first robot controller and a second enclosure 104 for a second robot controller. In the implementation illustrated in Figures 1a and 1b, the first enclosure 102 is stacked on top of the second enclosure 104 using multiple side plates 105. However, in other implementations, more than two enclosures may be stacked on top of each other to preserve production floor space.

It is desirable for an enclosure 102, 104 for a robot controller to keep a robot controller within the enclosure dry in a washdown environment or dust-free in a dusty environment. To keep the robot controller dry, first, water should be kept from entering into an interior of the enclosure during the washdown process, and second, any moisture that seeps into the interior of the enclosure or that enters the enclosure via humid air should be eliminated. Similarly, to keep the robot controller dust-free, dust should be kept from entering the interior of the enclosure from the dusty environment.

Referring to Figs. 1a and 1b, implementations of the enclosure 102 may include a first cooling fan 106 positioned as an air inlet fan on an exterior shell 108 of the enclosure 102 and a second cooling fan 110 positioned as an air exhaust fan on the exterior shell 108 of the enclosure 102. The exterior shell 108 defines an interior area that is sized to enclose a robot controller of an industrial machine. In some implementations, the interior area of the exterior shell 108 may define approximately 26,900 cubic inches. However, one of skill in the art will appreciate that that the exterior shell may be sized to accommodate any sized component of a robot controller and an airflow around the robot controller.

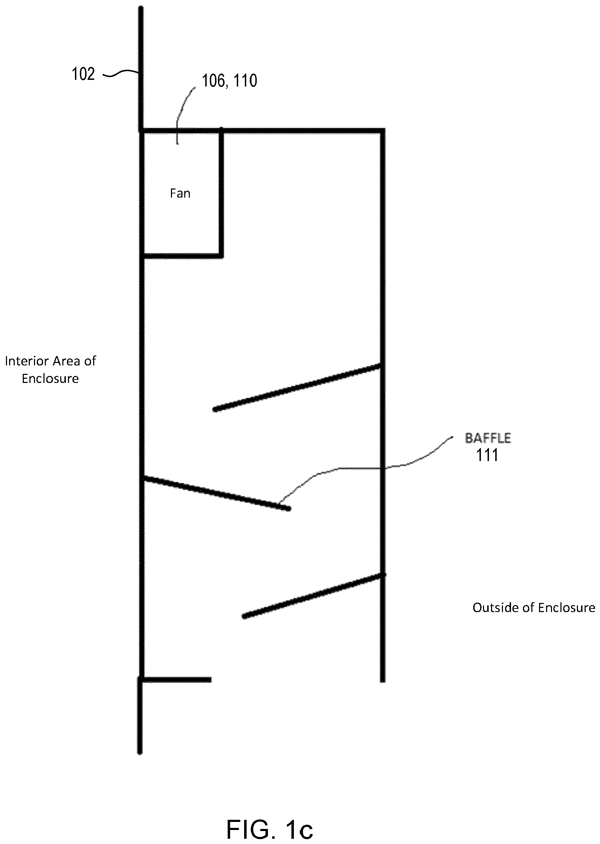

The first cooling fan 106 and the second cooling fan 110 may include one or more baffles 111 that are mounted to the exterior shell 108. The baffles at the first cooling fan 106 and the second cooling fan 110 prevent water from entering the interior area of the enclosure 102 through the first cooling fan 106 and/or the second cooling fan 110. Figure 1c illustrates a cut-away side view of a fan 106, 110 and associated baffles 111 positioned on the exterior shell 108.

In some implementations, the first cooling fan 106 may include a removable filter that prevents dust from entering the interior area of the disclosure at the first cooling fan 106. Similarly, in some implementations, the second cooling fan 110 may also include a removable filter that prevents dust from entering the interior area of the disclosure at the second cooling fan 110. In some implementations, the removable filter of the fans may be cleanable for reuse.

In some implementations, the first cooling fan 106 and the second cooling fan 110 are configured to move between 155 and 500 cubic feet per minute (CFM). Further, in some implementations, the first cooling fan 106 is positioned on the exterior shell 108 adjacent to or near a base 118 of the interior of the enclosure 102 to improve airflow through the interior of the enclosure 102. Further, in some implementations, the second cooling fan 110 may be positioned on the exterior shell 108 adjacent to or near a top of the exterior shell 108 to assist in airflow and expelling at least one of water or moisture from the interior of the enclosure 102.

As illustrated in Figs. 1a and 1b, the exterior shell 108 may additionally include access panels 112, provided with seals, that provide access to the interior area of the enclosure 102 without having to remove the exterior shell 108 from the base 118.

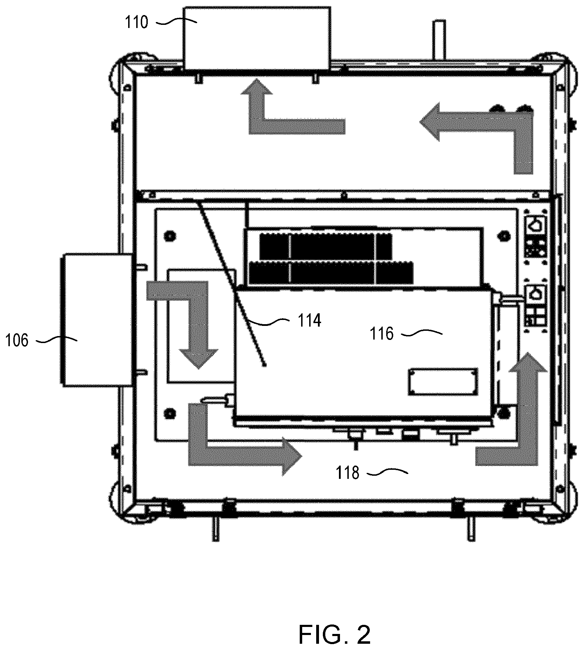

Referring to Fig. 2, the interior area of the enclosure 102 also includes a set of baffles 114. The baffles 114 positioned in the interior of the enclosure 102 assist in redirecting airflow though the interior of the enclosure 102, as explained in more detail below.

Humid air and seeping moisture are controlled within the interior area of the enclosure 102 by having a constant airflow within the interior area of the enclosure 102 that is sufficient to expel the humid air and moisture from the interior area, cause the moisture in the interior area to evaporate, and/or prevent humid air from condensing in the interior area. Accordingly, the airflow through the enclosure 102 should be maintained in order to protect the robot controller.

As illustrated in Fig. 2, air enters the interior area of the enclosure at the first cooling fan 106 positioned as an air inlet. One or more baffles 114 then direct the airflow around an exterior of the robot controller 116 and through the interior area of the enclosure 102 until the airflow exits the interior of the enclosure at the second cooling fan 110 positioned as an air exhaust. In some implementations some of the one or more baffles 114 are mounted to the base 118 of the enclosure. However, in other implementations, at least some of the one or more baffles 114 may be mounted on other portions of the enclosure 102. Additionally, while the implementations illustrated in Fig. 2 includes two fans, in other implementations, the enclosure may utilize one fan or more than two fans.

In some implementations, the airflow within the interior area of the enclosure 102 accommodates one or more cooling fans 120 that are present on the robot controller 116 itself. For example, a direct air path from the first cooling fan 106 positioned as the inlet fan to second cooling fan 110 positioned as the exhaust fan is avoided. If a direct air path were to exist between the first and second cooling fans 106, 110, the hot air generated by the robot controller 116 would not be flushed out of the enclosure 102. As described above, in some implementations the baffles 114 prevent a direct air path between the first and second cooling fans 106, 110 by directing air from the first cooling fan 106 away from the second cooling fan 110. Additionally, in some implementations, the baffles 114 direct the airflow around the interior of the enclosure 102 as shown in Fig. 2 to flow at least partially around the robot controller 116 and to provide a circular flushing of air within the interior area of the enclosure 102.

In some alternative implementations, rather than utilizing first and second fans 106, 110, an air conditioning unit is positioned on the enclosure 102. Similar to the cooling fans, the air conditioning unit may include baffles to prevent water from entering the interior area of the enclosure 102 at the air conditioning unit and/or the air conditioning unit may include a filter to prevent dust from entering the interior area of the enclosure 102 at the air conditioning unit.

In implementations utilizing an air conditioning unit, an air inlet of the air condition and an air outlet of the air conditioning unit are positioned on the enclosure 102 to create a circular airflow in the interior area of the enclosure 102 at least partially around a robot controller positioned in the interior area of the enclosure 102, similar to the airflow described above that is generated by the first and second fans 106, 110. In these implementations, baffles 114 within the interior area of the enclosure 102 prevent airflow directly between the air inlet and air outlet of the air conditioning unit and direct the airflow around the robot controller. In some implementations, the air inlet of the air conditioner is positioned near a top of the enclosure 102 and the air outlet of the air conditioning is positioned near a bottom of the enclosure 102 near a base 118 to assist in generating the circular airflow in the interior area of the enclosure 102.

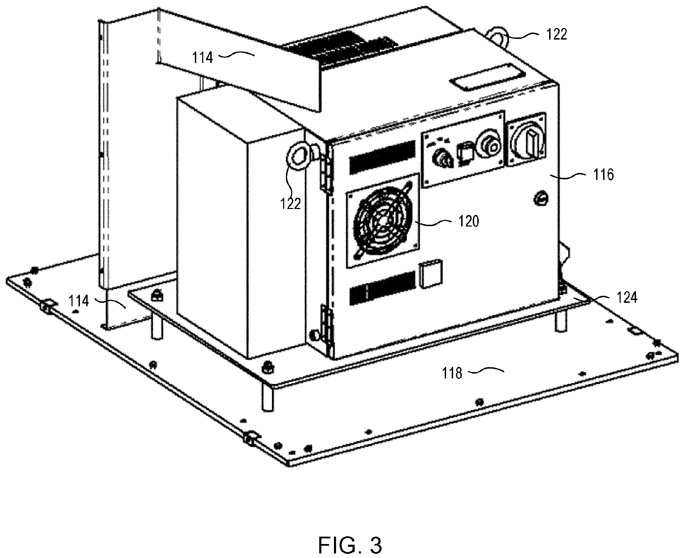

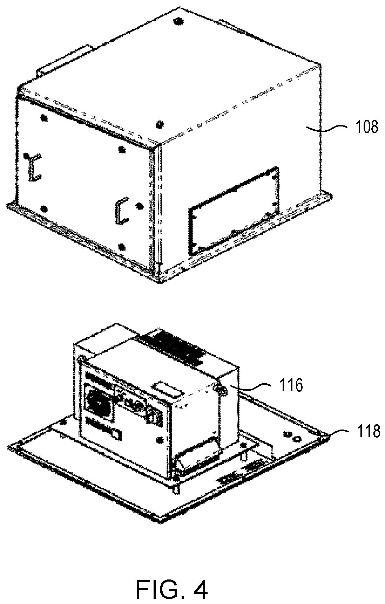

Referring to Figs. 3 and 4, typical robot controllers 116 are heavy and must be handled with care. Therefore, it can be difficult to insert robot controllers 116 into a conventional electronics cabinet that only has one door. As shown in Figs. 3 and 4, enclosures 102, 104 of the present disclosure are equipped with a removable exterior shell 108 that can be safely lifted off a base 118. With the exterior shell 108 removed from the base 118, installers can use recommended lifting eyes 122 and an overhead crane to safely put the robot controller 116 in place on a mounting plate 124. The shell 108 is also equipped with one or more configurable access panels 112 to allow access to the robot controller 116 once the exterior shell 108 is installed. The access panels 112 provide access to wiring points and maintenance areas in the interior of the enclosure 102, for use in situations such as if a cooling fan 120 on the robot controller 116 needs to be replaced.

As noted above, since floor space is very valuable within a manufacturing area, two or more enclosures 102, 104 can be stacked one on top of the other by using side plates 105. In some implementations, multiple enclosures are utilized when two or more robots operate within the same cell at an industrial facility.

Figures 1-4 illustrate a system including one or more enclosures 102 that provide an exterior shell 108 defining an interior area that is configured to cover and protect a robot controller. This exterior shell 108 is designed so that it can be lifted on and off of a base 118 such that a mounting of the heavy robot controller can be done easily and safely. In some implementations, an inlet fan 106 and an outlet fan 110 positioned on the exterior shell provide air circulation through the interior area of the enclosure 102 around the robot controller. In other implementations, an air inlet and an air outlet of an air conditioning unit positioned on the exterior shell provide air circulation through the interior area of the enclosure 102 and around the robot controller. In either type of implementation, baffles 114 within the interior area of the enclosure 102 are mounted strategically to ensure that hot air generated by the robot controller is flushed from the interior area of the enclosure 102, as well as moist humid air or water spray that may enter the interior area of the enclosure 102 during a washdown.

Although certain embodiments and implementations of the disclosure have been specifically described herein, it will be apparent to those skilled in the art to which the disclosure pertains that variations and modifications of the various embodiments shown and described herein may be made without departing from the spirit and scope of the disclosure. Accordingly, it is intended that the disclosure be limited only to the extent required by the appended claims and the applicable rules of law.

## Claims

1. A system configured to enclose one or more robot controllers, comprising:
a base;
an exterior shell configured to couple with the base, the exterior shell defining an interior area sized to enclose a robot controller of an industrial machine;
a first cooling fan positioned on the exterior shell, wherein the first cooling fan is configured to draw air into the interior area of the exterior shell and the first cooling fan comprises a baffle positioned on the exterior shell that is configured to prevent water from entering the interior area of the exterior shell at the first cooling fan; and
a second cooling fan positioned on the exterior shell, wherein the second cooling fan is configured to expel at least one of air or moisture from the interior area of the exterior shell and the second cooling fan comprises a baffle positioned on the exterior shell that is configured to prevent water from entering the interior area of the exterior shell at the second cooling fan.

2. The system according to claim 1, wherein at least one of the first fan or the second fan comprises a filter configured to prevent dust from entering the interior area of the enclosure.

3. The system according to any one of the preceding claims, wherein the first cooling fan is positioned on the exterior shell adjacent to the base.

4. The system according to any one of the preceding claims, wherein the second cooling fan is positioned on the exterior shell adjacent to a top of the exterior shell.

5. The system according to any one of the preceding claims, wherein the first and second cooling fans are positioned on adjacent walls of the exterior shell.

6. The system according to any one of the preceding claims, wherein the system comprises at least one interior baffle configured to disrupt a direct air path between the first and second cooling fans.

7. The system according to claim 6, wherein an interior baffle of the at least one interior baffle is mounted to the base and positioned to direct air from the first cooling fan away from the second cooling fan.

8. The system according to any one of claims 6-7, wherein the at least one interior baffle is positioned to cause air entering the interior area of the exterior shell at the first cooling fan to flow at least partially around a robot controller positioned in the interior area before at least one of air or moisture exits the interior area of the exterior shell at the second cooling fan.

9. The system according to any one of the preceding claims, further comprising:
a second base configured to stack on top of the exterior shell;
a second exterior shell configured to couple with the second base, the second exterior shell defining an interior area sized to enclose a robot control of an industrial machine;
a third cooling fan positioned on the second exterior shell, wherein the third cooling fan is configured to draw air into the interior area of the second exterior shell and the third cooling fan comprises a baffle positioned on the second exterior shell that is configured to prevent water from entering the interior area of the second exterior shell at the third cooling fan; and
a fourth cooling fan positioned on the second exterior shell, wherein the fourth cooling fan is configured to expel at least one of air or moisture from the interior area of the second exterior shell and the fourth cooling fan comprises a baffle positioned on the second exterior shell that is configured to prevent water from entering the interior area of the second exterior shell at the fourth cooling fan.

10. A system configured to enclose a plurality of robot controllers for one or more industrial machines, the system comprising a plurality of enclosures stacked on top of each other, wherein each enclosure comprises:
a base;
an exterior shell configured to couple with the base, the exterior shell defining an interior area sized to enclose a robot controller;
a first cooling fan positioned on the exterior shell, wherein the first cooling fan is configured to draw air into the interior area of the exterior shell and the first cooling fan comprises a baffle positioned on the exterior shell that is configured to prevent water from entering the interior area of the exterior shell at the first cooling fan; and
a second cooling fan positioned on the exterior shell, wherein the second cooling fan is configured to expel at least one of air or moisture from the interior area of the exterior shell and the second cooling fan comprises a baffle positioned on the exterior shell that is configured to prevent water from entering the interior area of the exterior shell at the second cooling fan.

11. The system according to claim 10, wherein the first cooling fan is positioned on the exterior shell adjacent to the base.

12. The system according to any one of claims 10-11, wherein the second cooling fan is positioned on the exterior shell adjacent to a top of the base.

13. The system according to any one of claims 10-12, wherein the first and second cooling fans are positioned on adjacent walls of the exterior shell.

14. The system according to any one of claims 10-13, wherein each enclosure further comprises at least one interior baffle configured to disrupt a direct air path between the first and second cooling fans.

15. A system configured to enclose one or more robot controllers, comprising:
a base;
an exterior shell configured to couple with the base, the exterior shell defining an interior area sized to enclose a robot controller of an industrial machine; and
an air conditioning unit positioned on the exterior shell, wherein the air conditioning unit is configured to create a circular airflow at least partially around the robot controller position in the interior area of the exterior shell.
